# EUROPEAN PATENT SPECIFICATION

(11) **EP 2 472 615 B1**
(45) Date of publication and mention of the grant of the patent: **20.04.2016**
(21) Application number: 11192972.5
(22) Date of filing: 12.12.2011
(51) Int. Cl.: H01L 33/52, B29C 43/18, B29C 43/20

(54) **Method for producing optical semiconductor device**
Verfahren zur Herstellung einer optischen Halbleitervorrichtung
Procédé pour la formation d'un dispositif semi-conducteur optique

(30) Priority: 28.12.2010 JP 2010292861
(43) Date of publication of application: 04.07.2012
(73) Proprietor: Nitto Denko Corporation, Osaka 567-8680 (JP)
(72) Inventor: Ooyabu, Yasunari, Osaka, 567-8680 (JP); Ito, Hisataka, Osaka, 567-8680 (JP); Shinbori, Yuki, Osaka, 567-8680 (JP); Sato, Satoshi, Osaka, 567-8680 (JP)
(74) Representative: Hoffmann Eitle

(56) References cited:
- EP-A1- 1 585 179
- EP-A2- 0 684 648
- EP-A2- 1 657 756
- JP-A- H06 163 617
- JP-A- H07 211 738
- JP-A- 2010 265 437
- US-A1- 2005 196 908
- US-B1- 6 881 611

## Description

### BACKGROUND OF THE INVENTION

### Field of the Invention

The present invention relates to a method for producing an optical semiconductor device including a sealing method.

### Description of Related Art

It has been known so far that an optical semiconductor element such as a light-emitting diode (LED) is sealed in with resin.

For example, Japanese Unexamined Patent Publication No. 2002-43345 has proposed a method for sealing in a molding object with a resin: in this method, a molding object on which a semiconductor chip and circuit components are mounted, and a metal mold for molding a sealing resin that seals in the molding object are disposed to face each other; a sealing resin is injected in the metal mold with the molding face of the metal mold covered with a releasing film; and the molding object and the sealing resin are pressed against each other.

In this method, the sealing in with resin is performed while the molding face of the metal mold is covered with a releasing film, and therefore the sealing resin is easily released from the metal mold, and at the same time, the sealing resin can be prevented from remaining in the metal mold.

Further examples of sealing optical elements are known from EP1657756 A2, and EP1585179 A1. A compression molding method using a releasing film for transporting the sealing resin is known from US2005/0196908A1.

### SUMMARY OF THE INVENTION

However, in the above-described method of Japanese Unexamined Patent Publication No. 2002-43345, every time the molding object is sealed in, the releasing film is sent out, and thereafter, the sealing resin is injected in the metal mold.

Therefore, a time period for re-injecting the sealing resin in the metal mold is necessary during the period after the current sealing operation and before the next sealing operation, and working efficiency may be reduced.

Thus, an object of the present invention is to provide a method for producing an optical semiconductor device including a sealing method.

A sealing member of the present disclosure includes an elongated releasing film, and a plurality of sealing resin layers composed of a sealing resin, the plurality of sealing resin layers being laminated on the releasing film so that the plurality of sealing resin layers are arranged in a row along the longitudinal direction of the releasing film with a space provided therebetween.

The sealing member of the present disclosure seals in an optical semiconductor element.

The sealing member of the present disclosure further includes a lens- forming resin layer composed of a lens-forming resin that forms a lens, and interposed between the releasing film and the sealing resin layer.

It is preferable that in the sealing member of the present disclosure, the sealing resin is a thermosetting resin, and the sealing resin layer is formed from the thermosetting resin in a B- stage state.

A sealing method of the present invention includes a repetition of the steps of: allowing the sealing resin layer and a sealing object to face each other while conveying the above described sealing member in a longitudinal direction; and pressing the sealing resin layer and/or the sealing object that are facing each other in a direction such that the sealing resin layer and the sealing object are brought closer, so as to seal in the sealing object with the sealing resin layer.

In a method for producing an optical semiconductor device of the present invention, the sealing object is an optical semiconductor element, and the above-described sealing method is included.

In the sealing method of the present disclosure, using a sealing member including an elongated releasing film, and a plurality of sealing resin layers laminated on the releasing film so as to be arranged in a row along the longitudinal direction of the releasing film with a space provided therebetween, the following is repeated: the sealing resin layer and a sealing object are allowed to face each other while the sealing member is conveyed in the longitudinal direction, and the sealing resin layer and/or the sealing object that are facing each other are pressed in a direction such that the sealing resin layer and the sealing object are brought closer, so as to seal in the sealing object with the sealing resin layer.

Therefore, the sealing object can be sealed in continuously by conveying the sealing member along the longitudinal direction, and successively sending out the sealing resin layers together with the releasing film.

Thus, when the sealing object is to be sealed, the releasing film and the sealing resin layer can be set simultaneously every time, and therefore the time for resetting the sealing resin layer can be shortened.

As a result, the sealing object can be sealed in efficiently and continuously, and an optical semiconductor device can be produced efficiently.

### BRIEF DESCRIPTION OF THE DRAWINGS

FIG. 1 is a cross section of a sealing member in an embodiment of the present disclosure.
FIG. 2 is a process diagram for describing a method for producing the sealing member shown in FIG. 1,
   (a) illustrating a step of forming a sealing resin layer on a base film, and
   (b) illustrating a step of forming a lens-forming resin layer on a releasing film.
FIG. 3 is, following FIG. 2, a process diagram for describing a method for producing a sealing member,
   (c) illustrating a step of laminating a sealing resin layer and a lens-forming resin layer,
   (d) illustrating a step of forming a cut having a predetermined shape in the base film, the sealing resin layer, and the lens-forming resin layer,
   (e) illustrating a step of removing a portion excluding the cut having the predetermined shape of the base film, the sealing resin layer, and the lens-forming resin layer, and
   (f) a step of removing the base film.

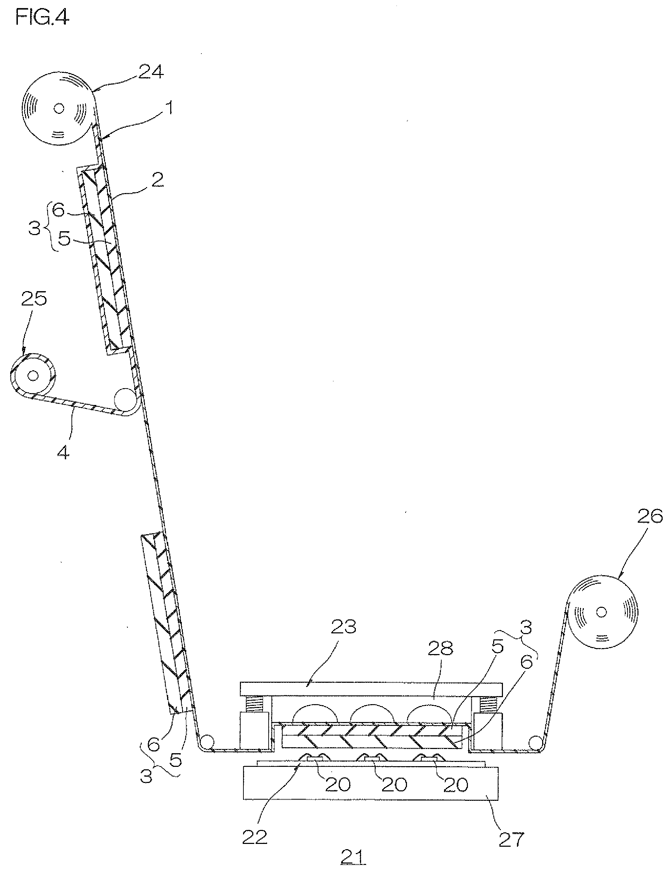

FIG. 4 is a diagram for describing an embodiment of a sealing method of the present disclosure, illustrating a step of allowing a sealing member and an optical semiconductor element to face each other.

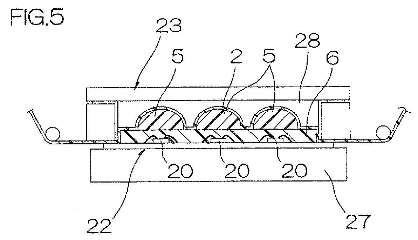

FIG. 5 is a diagram for describing the sealing method shown in FIG. 4, illustrating a step of sealing in an optical semiconductor element.

### DETAILED DESCRIPTION OF THE INVENTION

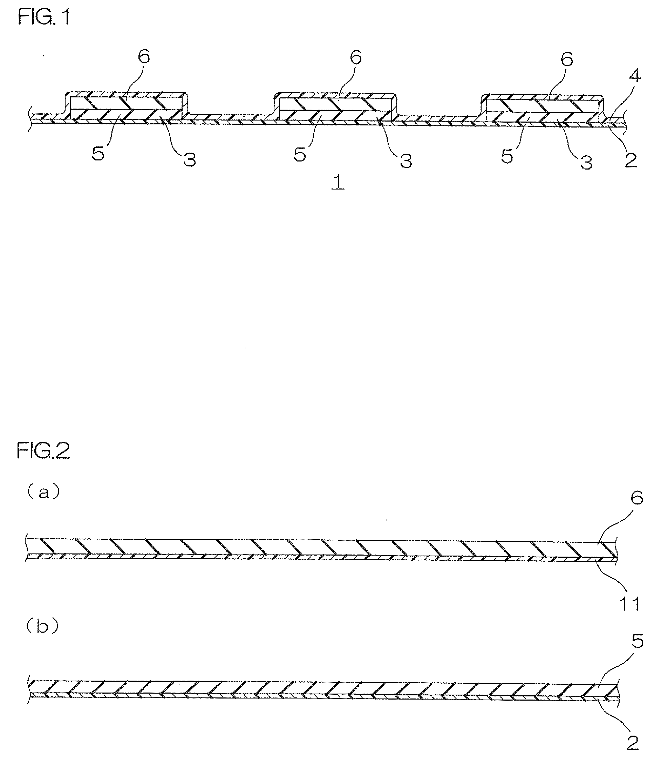

FIG. 1 is a cross section of a sealing member in an example of the present disclosure.

A sealing member 1 includes, as shown in FIG. 1, a releasing film 2; a plurality of sealing layers 3 laminated on the releasing film 2; and a protection film 4 laminated on the releasing film 2 so as to cover the sealing layer 3. The sealing member 1 is used for sealing in an optical semiconductor elements including a light-emitting element (ex. a light-emitting diode (LED)) and a light-receiving element. In this embodiment, description is given using an LED as an example of the sealing object.

The releasing film 2 is formed into an elongated flat belt shape.

The sealing layers 3 are formed into a generally circular shape when viewed from the top, and are arranged in a row along the longitudinal direction of the releasing film 2 with a space provided therebetween. The sealing layer 3 includes a lens-forming resin layer 5 that is formed into a lens, and a sealing resin layer 6 that seals in an LED.

The lens-forming resin layer 5 is transparent, formed into a generally circular shape when viewed from the top, and is laminated on the releasing film 2.

The sealing resin layer 6 is transparent, formed into a generally circular shape when viewed from the top having about the same diameter with the lens-forming resin layer 5, and formed on the lens-forming resin layer 5 so as to share the center with the lens-forming resin layer 5.

That is, the lens-forming resin layer 5 is interposed between the releasing film 2 and the sealing resin layer 6.

The protection film 4 is formed into generally the same shape (elongated flat belt shape) as that of the releasing film 2.

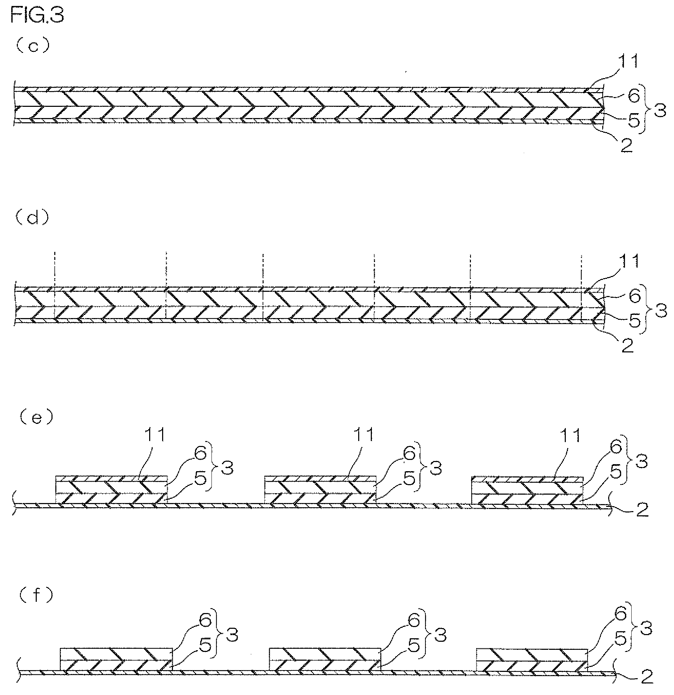

FIG. 2 and FIG. 3 are process diagrams for describing the method for producing a sealing member shown in FIG. 1.

To produce the sealing member 1, as shown in FIG. 2 (a), first, the sealing resin layer 6 is formed on the base film 11.

The base film 11 is formed into an elongated flat belt shape from, for example, polyesters such as polyethylene terephthalate; and polyolefins such as polyethylene and polypropylene.

The base film 1 has a thickness of, for example, 12 to 250 µm, or preferably 25 to 75 µm.

Examples of sealing resins that form the sealing resin layer 6 include thermosetting resins such as thermosetting silicone resin, epoxy resin, thermosetting polyimide resin, phenolic resin, urea resin, melamine resin, unsaturated polyester resin, diallyl phthalate resin, and thermosetting urethane resin, and a preferable example is a thermosetting silicone resin.

To form the sealing resin layer 6, a solution of the sealing resin is applied on the base film 11, and dried, thereby producing a sealing resin layer 6 in a semi-cured state (B-STAGE). The solvent for dissolving the sealing resin is not particularly limited, and examples thereof include known organic solvents.

To allow the sealing resin layer 6 to reach the B-STAGE, the sealing resin layer 6 is heated, for example, at 40 to 150°C for 1 to 60 min.

To cure the sealing resin layer 6 completely, the sealing resin layer 6 is heated, for example, at 125 to 250°C for 5 minutes to 24 hours.

In the solution of the sealing resin, for example, phosphor particles and silica particles may be blended.

Examples of phosphor particles include particles composed of a phosphor such as Y3Al₅O₁₂: Ce (YAG (yttrium · aluminum · garnet): Ce).

The phosphor particles are blended at a proportion of, for example, 1 to 10 mass% relative to the total solid content in the solution of the sealing resin.

Examples of silica particles include silica particles having an average particle size (volume-based, measured by dynamic light scattering method) of 20 nm or less.

The silica particles are blended at a proportion of, for example, 5 to 20 mass% relative to the total solid content in the solution of the sealing resin.

Examples of methods for applying the solution of the sealing resin onto the base film 11 include methods using doctor blades, gravure coaters, and fountain coaters.

Although not limited, the solution of the sealing resin applied on the base film 11 is dried, for example, at 100 to 150°C for 5 to 30 min.

The obtained sealing resin layer 6 has a thickness of, for example, 300 to 500 µm.

To produce a sealing member 1, as shown in FIG. 2 (b), a lens-forming resin layer 5 is separately formed on the releasing film 2.

The releasing film 2 is formed, for example, into an elongated flat belt shape from a fluorine resin such as ethylene-tetrafluoroethylene copolymer resin.

The releasing film 2 has a thickness of, for example, 12 to 250 µm, or preferably 25 to 75 µm.

Examples of lens-forming resins that form the lens-forming resin layer 5 include the above-described resins for the sealing resin.

To form the lens-forming resin layer 5, in the same manner as the above-described sealing resin layer 6, a lens-forming resin or a solution thereof is applied on the releasing film 2, and heated or dried, thereby producing a lens-forming resin layer 5 in a semi-cured state (B-STAGE). The solvent for dissolving the lens-forming resin is not particularly limited, and examples thereof include known organic solvents.

In the solution of the lens-forming resin, for example, the above-described silica particles may be blended.

The silica particles are blended at a proportion of, for example, 5 to 20 mass% relative to the total solid content in the solution of the lens-forming resin.

Examples of methods for applying the solution of the lens-forming resin onto the releasing film 2 include methods using comma coaters, doctor blades, gravure coaters, and fountain coaters.

Although not limited, the solution of the lens-forming resin applied on the releasing film 2 is dried, for example, by heating at 100 to 150°C for 5 to 30 min.

The obtained lens-forming resin layer 5 has a thickness of, for example, 100 to 1200 µm, or preferably 600 to 900 µm.

Then, to produce a sealing member 1, as shown in FIG. 3 (c), the sealing resin layer 6 and the lens-forming resin layer 5 are bonded together, and pressed under normal temperature at a predetermined pressure.

This allows the sealing resin layer 6 and the lens-forming resin layer 5 to be laminated, thereby forming a sealing layer 3.

Then, as shown in FIG. 3 (d), using a circular die cutting blade, a plurality of generally circular cuts when viewed from the top are formed on the base film 11 and the sealing layer 3 (the sealing resin layer 6 and the lens-forming resin layer 5) along the longitudinal direction of the releasing film 2 with a space provided therebetween; and as shown in FIG. 3 (e), portions excluding the generally circular shape (when viewed from the top) portions of the base film 11 and the sealing layer 3 are removed.

In this way, a plurality of sealing layers 3 are formed along the longitudinal direction of the releasing film 2 with a space provided therebetween.

The sealing layer 3 has a diameter of, for example, 50 to 300 mm, or preferably 100 to 200 mm. The sealing layers 3 are spaced apart by, for example, 20 to 1000 mm, or preferably 50 to 200 mm.

Then, as shown in FIG. 3 (f), after removing the remained base film 11, as shown in FIG. 1, the protection film 4 is laminated on the releasing film 2 so as to cover the sealing layer 3.

The protection film 4 is formed, for example, into an elongated flat belt shape from polyolefins such as polyethylene and polypropylene.

The protection film 4 has a thickness of, for example, 12 to 250 µm, or preferably 25 to 50 µm.

The sealing member 1 is obtained in this manner.

The steps for producing the above-described sealing member 1 are performed, industrially, by roll-to-roll processing.

FIG. 4 and FIG. 5 are diagrams for describing an embodiment of a sealing method of the present invention.

Next, a method for producing an LED device using the obtained the sealing member 1 to seal in LEDs 20 is described. In this method, as shown in FIG. 4, using a sealing device 21, while the sealing member 1 is successively sent out, the sealing layer 3 and a light-emitting substrate 22 including the LEDs 20 are allowed to face each other, and the LEDs 20 are sealed in continuously.

In particular, the sealing device 21 includes a pressing unit 23, a sealing member feed unit 24, a protection film release unit 25, and a releasing film take-up unit 26.

The pressing unit 23 includes a base portion 27 on which the light-emitting substrate 22 is placed; and a metal mold 28 that is disposed above and facing the base portion 27 and that has a plurality of hemispherical depressions. The pressing unit 23 presses, while heating, the sealing layer 3 and the light-emitting substrate 22 that are facing each other in a direction in which the sealing layer 3 and the light-emitting substrate 22 are brought closer.

The sealing member feed unit 24 is disposed upstream with respect to the pressing unit 23 in the conveying direction of the sealing member 1; retains the sealing member 1 in a rolled state; and conveys the retained sealing member 1 along the longitudinal direction of the sealing member 1 towards the pressing unit 23 (between the base portion 27 and the metal mold 28).

The protection film release unit 25 is disposed between the pressing unit 23 and the sealing member feed unit 24 in the conveying direction of the sealing member 1, and peels off the protection film 4 from the sealing member 1 while winding the peeled protection film 4 into a rolled state.

The releasing film take-up unit 26 is disposed downstream with respect to the pressing unit 23 in the conveying direction of the sealing member 1, and winds and takes up the used releasing film 2.

Then, to continuously seal in the LEDs 20 using the sealing device 21, first, the light-emitting substrate 22 on which a plurality of LEDs 20 are mounted is placed on the base portion 27 of the pressing unit 23. At the same time, the sealing member 1 is sent out from the sealing member feed unit 24 towards a space between the metal mold 28 and the light-emitting substrate 22.

At this time, on the way from the sealing member feed unit 24 to the pressing unit 23, the protection film 4 is peeled off from the sealing member 1 by the protection film release unit 25, and the sealing resin layer 6 of the sealing layer 3 is exposed.

Then, the sealing member 1 is successively sent out, the sealing layer 3 is disposed above the light-emitting substrate 22 on which the LEDs 20 are mounted so that the sealing resin layer 6 is exposed downward and the releasing film 2 faces the metal mold 28. The sealing resin layer 6 and the LEDs 20 are thus allowed to face each other vertically.

Then, while heating, the metal mold 28 is brought closer to the base portion 27, and, while heating, the sealing layer 3 is pressed against the light-emitting substrate 22.

The temperature of the metal mold 28 is, for example, 120 to 200°C, or preferably 140 to 165°C.

The base portion 27 is pressed against the metal mold 28 at, for example, 0.01 to 10 MPa, or preferably 0.1 to 4 MPa.

The LEDs 20 are thus embedded in the sealing resin layer 6. In addition, the lens-forming resin layer 5 of the sealing layer 3 is injected into the depressions of the metal mold 28. At this time, the releasing film 2 is deformed so as to conform to the depressions of the metal mold 28, protecting the internal face of the depressions of the metal mold 28, and also allowing the entrance of the lens-forming resin layer 5 into the depressions of the metal mold 28.

Then, as shown in FIG. 5, by subsequently heating the sealing layer 3, the sealing resin layer 6 and the lens-forming resin layer 5 are completely cured.

Next, the metal mold 28 is brought away upward from the base portion 27 so as to be spaced apart therefrom, thereby opening the mold. This allows the releasing film 2 to be released from the depressions of the metal mold 28.

In this fashion, the LEDs 20 are sealed in with the sealing resin layer 6, and at the same time, the lens-forming resin layer 5 is molded into lenses.

Next, while releasing the releasing film 2 from the light-emitting substrate 22 in which the LEDs 20 are sealed in with the sealing layer 3, the light-emitting substrate 22 in which the LEDs 20 are sealed in with the sealing layer 3 is removed from the base portion 27, and then a new light-emitting substrate 22 is placed on the base portion 27.

At the same time, while winding up the peeled releasing film 2 with the releasing film take-up unit 26, the sealing member 1 is sent out from the sealing member feed unit 24.

Then, as described above, a sealing resin layer 6 and LEDs 20 are allowed to face each other vertically again.

In this way, the steps are repeated, i.e., the step of allowing the sealing resin layer 6 and the LEDs 20 to face each other while conveying the sealing member 1, and the step of pressing the sealing resin layer 6 facing the LEDs 20 towards and against the LEDs 20, thereby sealing in the LEDs 20 with the sealing resin layer 6.

In this way, using the sealing device 21, the LEDs 20 can be sealed in continuously.

In this sealing method, as shown in FIG. 4, using the sealing member 1 including the elongated releasing film 2 and the plurality of sealing resin layers 6 laminated on the releasing film 2 and arranged in a row along the longitudinal direction of the releasing film 2 with a space provided therebetween, the following is repeated: while conveying the sealing member 1 in the longitudinal direction, the sealing resin layer 6 and the LEDs 20 are allowed to face each other, and the sealing resin layer 6 facing the LEDs 20 is pressed toward and against the LEDs 20, thereby sealing in the LEDs 20 with the sealing resin layer 6.

Therefore, the LEDs 20 can be continuously sealed in by conveying the sealing member 1 along the longitudinal direction, and successively sending out the sealing resin layers 6 together with the releasing film 2.

Therefore, when sealing in the LEDs 20, the releasing film 2 and the sealing resin layer 6 can be set simultaneously every time, which allows shortening of time for re-setting the sealing resin layer 6.

As a result, the LEDs 20 can be efficiently and continuously sealed in.

Furthermore, in this sealing method, the sealing member 1 includes a lens-forming resin layer 5.

Thus, simultaneously with the sealing in of the LEDs 20, lenses can be formed.

As a result, by using this sealing method to seal in the LEDs 20, an LED device can be produced efficiently.

### Examples

While the present invention is described in further detail with reference to Examples in the following, the present invention is not limited to any of them by no means.

### 1. Production of Sealing Member

A thermosetting silicone resin containing 5 mass% of Y₃Al₅O₁₂. Ce phosphor particles, and 10 mass% of silica particles having an average particle size (volume-based, measured by dynamic light scattering method) of 20 nm or less was applied on the releasing face of an elongated base film composed of polyethylene terephthalate and having a thickness of 50 µm, and heated at 120°C for 10 min, thereby producing a sealing resin layer (ref: FIG. 2 (a)) having a thickness of 400 µm in a semi-cured state (B-STAGE).

Separately, a thermosetting silicone resin containing 10 mass% of silica particles having an average particle size (volume-based, measured by dynamic light scattering method) of 20 nm or less was applied on an elongated releasing film composed of an ethylene-tetrafluoroethylene copolymer resin and having a thickness of 50 µm, and heated at 120°C for 10 min, thereby producing a lens-forming resin layer (ref: FIG. 2 (b)) having a thickness of 600 µm in a semi-cured state (B-STAGE).

Then, the obtained sealing resin layer and the lens-forming resin layer were bonded together, and a pressure was applied at a predetermined pressure and normal temperature, laminating the sealing resin layer and the lens-forming resin layer, thereby forming a sealing layer (ref: FIG. 3 (c)).

Then, a plurality of generally circular cuts having a diameter of 150 mm when viewed from the top were formed in the base film and the sealing layer (the sealing resin layer and the lens-forming resin layer) using a circular die cutting blade along the longitudinal direction of the releasing film with a distance of 150 mm provided therebetween (ref: FIG. 3 (d)), and portions of the base film and the sealing layer excluding the portions of the generally circular shape when viewed from the top were removed (ref: FIG. 3 (e)).

In this way, a plurality of sealing layers having a generally circular shape when viewed from the top and having a diameter of 150 mm were formed along the longitudinal direction of the releasing film with a distance of 150 mm provided therebetween.

Then, after removing the remaining base film (ref: FIG. 3 (f)), an elongated protection film composed of polypropylene was laminated on the releasing film so as to cover the sealing layer (ref: FIG. 1).

A sealing member was obtained in this manner.

### 2. Sealing in of Optical Semiconductor Element

Using the sealing device shown in FIG. 4, while sending out the sealing member successively, the sealing layer, and a light-emitting substrate including the LEDs were allowed to face each other, and the LEDs were continuously sealed in.

Specifically, a light-emitting substrate on which a plurality of LEDs are mounted was placed on the base portion of the pressing unit. At the same time, the sealing member was sent out from the sealing member feed unit towards a space between the metal mold and the light-emitting substrate.

At this time, on the way from the sealing member feed unit to the pressing unit, the protection film was peeled off by the protection film release unit from the sealing member, thereby exposing the sealing resin layer of the sealing layer.

Thereafter, the sealing member was sent out, and the sealing layer was disposed above the light-emitting substrate on which LEDs were mounted so that the sealing resin layer was exposed downwardly and at the same time the releasing film faced the metal mold. The sealing resin layer and the LEDs were allowed to face each other vertically in this manner (ref: FIG. 4).

Then, while heating at 160°C, the metal mold was brought closer to the base portion at an applied pressure of 2.77 MPa, and the sealing layer, while heating, was pressed against the light-emitting substrate.

The LEDs were embedded in the sealing resin layer in this manner. Also, the lens-forming resin layer of the sealing layer was injected in the depressions of the metal mold.

Subsequently, the sealing layer was heated, thereby completely curing the sealing resin layer and the lens-forming resin layer (ref: FIG. 5).

Then, the metal mold was brought away upward so as to be spaced apart from the base portion, thereby opening the mold.

In this fashion, the LEDs were sealed in with the sealing resin layer, and at the same time, the lens-forming resin layer was molded into a lens.

Then, while peeling off the releasing film from the light-emitting substrate in which the LEDs were sealed in with the sealing layer, the light-emitting substrate in which the LEDs were sealed in with the sealing layer was removed from the base portion, and thereafter, a new light-emitting substrate was placed on the base portion.

At the same time, while winding the peeled releasing film onto the releasing film take-up unit, the sealing member was sent out from the sealing member feed unit.

The sealing resin layer and LEDs were allowed to face each other vertically again in this manner.

As described above, while conveying the sealing member, the following steps were repeated: a step of allowing the sealing resin layer and LEDs to face each other, and a step of pressing the sealing resin layer facing the LEDs towards the LEDs, thereby sealing in the LEDs with the sealing resin layer.

While the illustrative embodiments of the present invention are provided in the above description, such is for illustrative purpose only and it is not to be construed as limiting the scope of the present invention. Modifications and variations of the present invention that will be obvious to those skilled in the art are to be covered by the following claims.

## Claims

1. A method for producing an optical semiconductor device comprising a repetition of the steps of:
preparing a sealing member comprising an elongated releasing film (2), a plurality of sealing resin layers (6) composed of a sealing resin, the plurality of sealing resin layers being laminated on the releasing film so that the plurality of sealing resin layers are arranged in a row along the longitudinal direction of the releasing film with a space provided therebetween, and a lens-forming resin layer (5) composed of a lens-forming resin that forms a lens, and interposed between the releasing film and the sealing resin layer,
allowing the sealing resin layer and an optical semiconductor element to face each other so that the releasing film faces a metal mold (28) while conveying the sealing member in a longitudinal direction, and
pressing the sealing resin layer and/or the optical semiconductor element that are facing each other by the metal mold in a direction such that the sealing resin layer and the optical semiconductor element are brought closer, so as to seal in the optical semiconductor element with the sealing resin layer, and
simultaneously with the sealing, deforming the releasing film so as to conform to the depressions of the metal mold and protect the internal face of the depressions of the metal mold, and also allow entrance of the lens-forming resin layer into the depressions of the metal mold, thereby forming the lens-forming resin layer into a lens.

## Patentansprüche

1. Verfahren zur Herstellung einer optischen Halbleitereinrichtung mit einer Wiederholung der Schritte:
Vorbereiten eines Einschlusselements, das einen gestreckten Ablösefilm (2), mehrere Einschlussharzschichten (6) bestehend aus einem Einschlussharz, wobei die mehreren Einschlussharzschichten so auf dem Ablösefilm laminiert werden, dass die mehreren Einschlussharzschichten in einer Reihe entlang der Längsrichtung des Ablösefilms mit einem dazwischen vorgesehenen Abstand darauf vorgesehen sind, und eine Linsenausbildungs-Harzschicht (5) aufweist, die aus einem Linsenausbildungsharz besteht, das eine Linse ausbildet und zwischen dem Ablösefilm und der Einschlussharzschicht eingefügt ist,
Gestatten, dass die Einschlussharzschicht und ein optisches Halbleiterelement so einander zugewandt werden, dass der Ablösefilm während des Transports des Einschlusselements in einer Längsrichtung, einer Metallform (28) zugewandt ist, und
Pressen der Einschlussharzschicht und/oder des optischen Halbleiterelements, die einander zugewandt sind, durch die Metallform in eine Richtung, sodass die Einschlussharzschicht und das optische Halbleiterelement einander derart nähergebracht werden, dass das optische Halbleiterelement durch die Einschlussharzschicht eingeschlossen wird, und
gleichzeitig mit dem Einschließen, Verformen des Ablösefilms derart, dass dieser sich den Ausnehmungen der Metallform anpasst und die innere Fläche der Ausnehmungen der Metallform schützt und auch das Einbringen der Linsenausbildungsharzschicht in die Ausnehmungen der Metallform gestattet, wodurch die Linsenausbildungsharzschicht zu einer Linse geformt wird.

## Revendications

1. Procédé de fabrication d'un dispositif optique semi-conducteur comprenant une répétition des étapes consistant à :
préparer un élément d'étanchéité comprenant un film anti-adhésif allongé (2), une pluralité de couches de résine d'étanchéité (6) composées d'une résine d'étanchéité la pluralité de couches de résine d'étanchéité étant stratifiées sur le film anti-adhésif de telle sorte que la pluralité de couches de résine d'étanchéité soient agencées en rangée dans la direction longitudinale du film anti-adhésif avec un espace ménagé entre elles, et une couche de résine formatrice de lentille (5) composée d'une résine formatrice de lentille qui forme une lentille et intercalée entre le film anti-adhésif et la couche de résine d'étanchéité,
permettre à la couche de résine d'étanchéité et à un élément optique semi-conducteur de se faire face de telle sorte que le film anti-adhésif soit en regard d'un moule métallique (28) tout en acheminant l'élément d'étanchéité t dans la direction longitudinale, et
comprimer la couche de résine d'étanchéité et/ou l'élément optique semi-conducteur se faisant face au moyen du moule métallique dans une direction permettant de rapprocher la couche de résine d'étanchéité et
l'élément optique semi-conducteur de sorte à étancher l'élément optique semi-conducteur avec la couche de résine d'étanchéité et
déformer, de manière simultanée avec l'étanchéité, le film anti-adhésif de sorte qu'il se conforme aux dépressions du moule métallique et protège la face interne des dépressions du moule métallique, et permette également à la couche de résine formatrice de lentille d'entrer dans les dépressions du moule métallique, conformant ainsi la couche de résine formatrice de lentille en lentille.
